# EUROPEAN PATENT APPLICATION

(11) **EP 4 576 224 A1**
(43) Date of publication of application: **25.06.2025**
(21) Application number: 23219037.1
(22) Date of filing: 21.12.2023
(51) Int. Cl.: H01L 29/775, H01L 21/336, H01L 29/06, H01L 29/08, H01L 29/165, H01L 29/78, H01L 29/423, B82Y 10/00

(54) **A METHOD FOR PRODUCING NANOSHEET TRANSISTORS**

(71) Applicant: Imec VZW, 3001 Leuven (BE)
(72) Inventor: Hellings, Mr. Geert, 1500 Halle (BE); Boemmels, Mr. Juergen, 3001 Leuven (BE); Ryckaert, Mr. Julien, 1030 Schaarbeek (BE)
(74) Representative: Patent Department IMEC

(57) **Abstract**

A fin-shaped structure (5) is formed on a base substrate (1), the structure comprising a stack of alternating sacrificial layers and semiconductor layers (3,4) Then the stack materials are removed relative to the dummy gates and relative to a mask (6) formed before or after the dummy gates,, thereby creating lateral recesses (14) with U-shaped sidewalls (15) formed of stacked U-shaped portions of the sacrificial and semiconductor layers (3,4). Semiconductor material is grown in the recesses by epitaxial growth, starting from the U-shaped semiconductor portions. The grown material is lattice mismatched relative to the material of the U-shaped portions. Because of the growth mechanism starting from the U-shaped semiconductor portions, no dislocations are created due to oppositely interfering growth fronts, and a desired stress can thereby be created in at least one or more channel sheets of the eventual transistors. These transistors are arranged in a forksheet configuration, after producing a trench to thereby remove the mask, and filling said trench by a dielectric material.

## Description

### Field of the Invention

The present invention is related semiconductor processing, in particular to the production of nanosheet transistors.

### State of the art.

Nanosheet technology has been under development for a number of years, and represents one of the main answers to the limitations of finFET technology in terms of the ongoing scaling requirements of active devices on an integrated circuit chip. In a standalone nanosheet transistor, the channel is formed of one or more semiconductor sheets stacked one on top of the other, with the gate dielectric as well as the gate electrode wrapped around the sheets. The term 'gate all around' (GAA) is also used for this type of device. A further development is the forksheet configuration, wherein two nanosheet transistors are built on either side of a separating dielectric wall.

Nevertheless, further challenges need to be met in terms of improving and finetuning the performance of nanosheet transistors. One of the problems is related to the epitaxial growth of source and drain areas in between adjacent dummy gate structures. In the currently applied production methods, a plurality of fin-shaped structures are formed from a stack of alternating sacrificial and semiconductor layers, for example SiGe alternated with Si. Dummy gates are then produced transversally with respect to the fin structures, followed by the formation of outer and inner spacers. Then the material of the fins is removed in between the dummy gates and source and drain areas are formed by epitaxial growth, starting on the lateral surfaces of semiconductor layers within the fin structures. The growth starts on opposite sides of the trench formed between two adjacent dummy gates, and continues until a bottom area of the trench is filled. This growth pattern is however not ideal in terms of obtaining stress in the eventual channel of the transistors, said stress being beneficial for optimizing the carrier mobility. The growth along two opposite fronts is likely to result in closeto-zero channel stress, due to a dislocation plane forming where the two growth fronts meet. These dislocations may lead to relaxation defects propagating to the interface between the seed layer and the grown layer, thereby eliminating any strain built up in the grown layer.

### Summary of the invention

The invention is related to a method for producing one or more nanosheet transistors in accordance with the appended claims. According to the method, a fin-shaped structure is formed on a base substrate, the structure comprising a stack of alternating sacrificial layers and semiconductor layers, the latter being suitable for the formation of channel sheets in the eventual one or more transistors. Then the stack materials are removed relative to the dummy gates and relative to a mask formed before or after the dummy gates, thereby creating lateral recesses with U-shaped sidewalls formed of stacked U-shaped portions of the sacrificial and semiconductor layers. Internal spacers are formed between the U-shaped semiconductor portions. Then semiconductor material is grown in the recesses by epitaxial growth, starting from the U-shaped semiconductor portions. The grown material is lattice mismatched relative to the channel material. By `lattice mismatched' is meant that there is a difference between the dimensions of the lattice structure of the channel material (acting as the seed layer of the epitaxial growth) and the grown material. Due to the nature of the epitaxial growth process, the lattice of the grown material adapts to the lattice of the seed layer, so that the seed layer and the grown layer are able to form a strained uniformly crystalline structure. Because of the growth mechanism starting from the U-shaped semiconductor portions, no dislocations are created due to oppositely interfering growth fronts. Hence no relaxation defects originating in such growth fronts are able to propagate to the interface between the seed layer and the grown layer, and a desired stress can thereby be created in at least one or more of the channel sheets of the eventual transistors. These transistors are arranged in a forksheet configuration, after producing a trench to thereby remove the mask, and filling said trench by a dielectric material.

The invention is in particular related to a method for producing one or more nano-sheet transistors, comprising the consecutively applied steps of :
- on a base substrate, producing at least one fin-shaped structure extending in a longitudinal direction, the structure comprising a stack of layers including one or more sacrificial layers and one or more crystalline semiconductor layers formed of a first semiconductor material, stacked in alternating order,
- producing at least three mutually parallel and spaced apart dummy gate structures arranged transversely with respect to and fully overlapping the fin-shaped structure and the mask,
- producing dielectric spacers at least on the sidewalls of the dummy gate structures,
- patterning the stack of sacrificial and semiconductor layers by removing the material of said layers relative to the dummy gate structures and the spacers, and relative to a mask formed prior to or after producing the dummy gate structures and extending in the same longitudinal direction as the fin-shaped structure, so that two lateral recesses having U-shaped sidewalls are formed in said stack on each side of at least one of the dummy gate structures having adjacent dummy gates on either side, said sidewalls comprising exposed U-shaped portions of the sacrificial and semiconductor layers,
- on the U-shaped sidewalls, producing inner spacers by etching back the exposed sacrificial material relative to the exposed semiconductor material, and replacing the thereby removed sacrificial material by a dielectric material,
- by epitaxial growth, growing a second semiconductor material in said lateral recesses, wherein :
   ∘ the second semiconductor material is lattice mismatched with respect to the first semiconductor material,
   ∘ the second semiconductor material grows outward starting from the exposed U-shaped portions of the layers of the first semiconductor material,
   ∘ the growth continues until a volume of the second semiconductor material is obtained in each of said lateral recesses,
- producing a dielectric layer that fills the spaces between every pair of adjacent dummy gate structures and planarizing said dielectric layer to a common level with the dummy gate structures,
- by lithography and etching, producing a trench along the longitudinal direction of the fin-shaped structure, said trench cutting through the dummy gate structures and the spacers, said trench being wider than the mask but narrower than the fin-shaped structure, so that the mask is removed while leaving portions of the stack of alternating sacrificial and first semiconductor layers on either side of the trench,
- filling the trench with a dielectric material, thereby forming a dielectric wall,
- removing the dummy gate structures and the remaining parts of the sacrificial layers, producing gate dielectric layers on the remaining parts of the first semiconductor layers and producing metal gates in direct contact with said gate dielectric layers on both sides of the dielectric wall,
- producing electrical connections to at least one metal gate and two epitaxially grown volumes directly adjacent and on either side of said gate, thereby obtaining at least one nano-sheet transistor comprising a channel, a source area and a drain area.
According to an embodiment, the fin-shaped structure comprises a dielectric layer directly on the base substrate and said stack of alternating sacrificial and semiconductor layers is formed directly on said dielectric layer.

According to an embodiment, spacers are also formed on the sidewalls of the mask and on the sidewalls of the fin-shaped structure.

According to an embodiment, the stack of alternating sacrificial and semiconductor layers comprises at least two semiconductor layers and one epitaxially grown volume is formed in each of the recesses, said volume being obtained by merged subvolumes growing outward from respective exposed U-shaped portions of the semiconductor layers.

According to an embodiment, said dielectric layer that fills the spaces between every pair of adjacent dummy gate structures is removed after the step of producing the trench, and a continuous layer of dielectric material is thereafter produced, said continuous layer filling the trench and the spaces between every pair of adjacent dummy gate structures.

According to an embodiment, said mask is a hardmask formed on the fin-shaped structure and covering a central elongate portion of said structure, and said hardmask is formed prior to the formation of the dummy gate structures.

According to an embodiment, said mask is a hardmask or a resist mask formed after the formation of the dummy gates and covering a central elongate portion of the fin-shaped structure.

The invention is also related to a forksheet configuration comprising a base substrate, a dielectric wall and two nanosheet transistors on opposite sides of said dielectric wall, each of the transistors comprising one or more channel sheets, a metal gate, a gate dielectric between the channel sheets and the metal gate, a source and a drain area, characterized in that in any cross section parallel to the base substrate and through at least one of the channel sheets, the source and drain areas and the channel sheet through which the cross section is taken are uniformly crystalline.

According to an embodiment of said forksheet configuration, a dielectric layer lies directly on the base substrate and the dielectric wall and the transistors are placed on the dielectric layer.

The invention is also related to a semiconductor component comprising one or more transistors produced according to the method the invention, and to a semiconductor component comprising one or more forksheet configurations according to the invention.

### Brief description of the figures

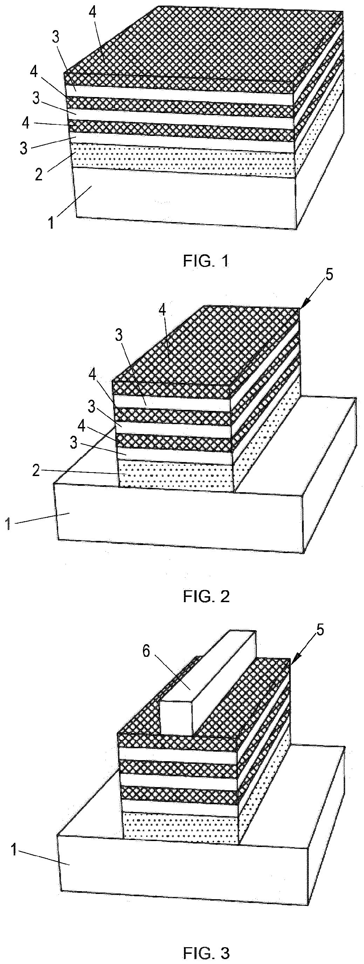

Figures 1 to 18 illustrate a number of method steps applicable in one embodiment of the method according to the invention.

### Detailed description of the invention

One embodiment of the method according to the invention will be described hereafter in some detail. Every reference to materials and dimensions is made only by way of example and is not intended to limit the scope of the invention, which is determined only by the appended claims.

Figure 1 shows a small portion of a base substrate 1 comprising a number of layers on its upper surface. The base substrate 1 may be a standard silicon process wafer having a diameter of 300 mm and a thickness between 0.4 and 0.5 mm. Only a thin upper portion of the wafer is shown, having a thickness in the order of 10-20 nm. Directly on the Si substrate is a silicon oxide layer (SiO₂) 2 of about 10 nm thick. On this SiO₂ layer 2, a stack of alternating SiGe layers 3 and Si layers 4 is present, each having a thickness of about 5 nm. The stack starts with a SiGe layer 3 at the bottom and ends with a Si layer 4 at the top. In the known process technology for producing nanosheet devices, as well as in the method according to the illustrated embodiment, the SiGe sheets have the function of sacrificial layers, to be removed at a later stage of the process. The Si layers are formed of crystalline Si. As known in the art, this can be realized by producing the subsequent SiGe and Si layers by epitaxial growth.

By lithography and etching of the SiGe and Si layers 3,4 and the SiO₂ layer 2, a fin-shaped structure 5 is formed, as illustrated in Figure 2, comprising the patterned stack of a SiO₂ layer 2 and alternating SiGe and Si layers 3,4. Only one fin-shaped structure 5 is shown, but in most implementations, it will be preferred to produce an array of multiple mutually parallel fin-shaped structures 5 of equal width and constant pitch. The width of the fin-shaped structure 5 is about 40 nm in this particular embodiment, but other widths are possible.

With reference to Figure 3, a hardmask 6 is then formed on top of the fin-shaped structure 5. This may be done by depositing a layer of hardmask material, for example SiN or SiC, and patterning the layer so that the mask 6 remains in the form of an elongate strip of mask material aligned to and on top of the fin-shaped structure 5. The width of the hardmask 6 may be between 10 and 15 nm in the particular embodiment illustrated. The mask 6 is preferably arranged coaxially with the fin-shaped structure 5. The mask 6 enables anisotropically etching the materials of the stack of SiGe and Si layers 3,4 (hereafter also referred to as 'the SiGe/Si stack 3,4') relative to the mask material.

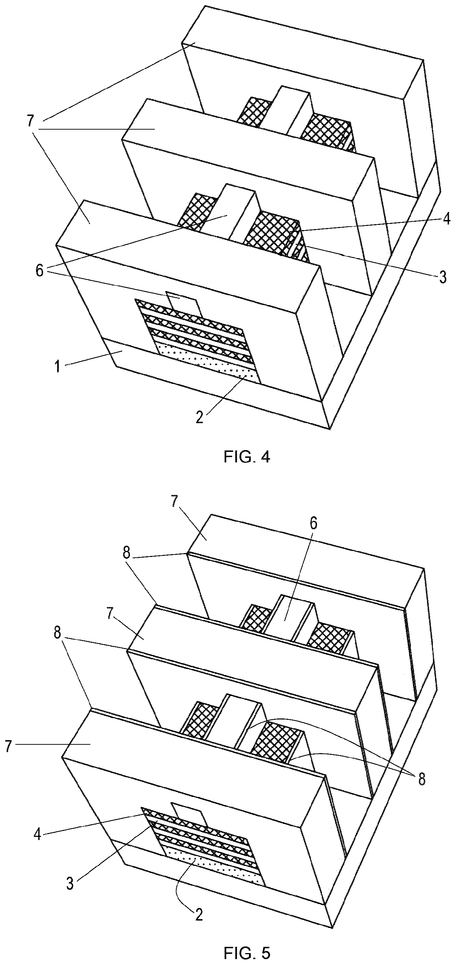

With reference to Figure 4, a regular array of dummy gate structures 7 (hereafter also referred to as 'dummy gates') is then formed transversely, preferably perpendicularly, with respect to the fin-shaped structure 5 and the mask 6. The width of the dummy gates 7 may be in the order of 10-15 nm. The material, for example amorphous silicon, and the production method of the dummy gates 7 may be in accordance with known process technology for producing dummy gate structures applicable in the well-established replacement metal gate (RMG) technique. The distance between two adjacent dummy gate structures 7 is a little larger than the dummy gate width in the example shown, but this distance may generally be in the same order of magnitude as the dummy gate width.

Then, as illustrated in Figure 5, dielectric spacers 8 are applied on the sidewalls of the dummy gate structures 7, again in accordance with known RMG technology. The spacers 8 may have a thickness in the order of 1 to 5 nm for example. The spacers are not shown on the first and last of the three dummy gates illustrated in Figure 5, in order to continue to visualize the fin-shaped structure 5, but it is to be understood that the spacers are effectively formed on both sides of every dummy gate 7. As known in the art, the formation of the spacers 8 can be done by the conformal deposition of a thin dielectric layer, i.e. following the topography of the fin-structure 5, the mask 6 and the dummy gates 7, and thereafter removing the dielectric from the level surfaces by plasma etching. In the embodiment shown, spacers are also formed on the sidewalls of the fin-shaped structure 5 and of the mask 6, in the areas between the dummy gate structures 7. Depending on the materials applied in the fin-shaped structure 5 and the mask 6 and/or on the process parameters applied for producing the spacers, it may be possible that no spacers are formed here, or that the spacers are only formed up to a given height. This will not have an influence on the method according to the invention however, as will become apparent. The material of the spacers 8 may for example be SiN or SiCN.

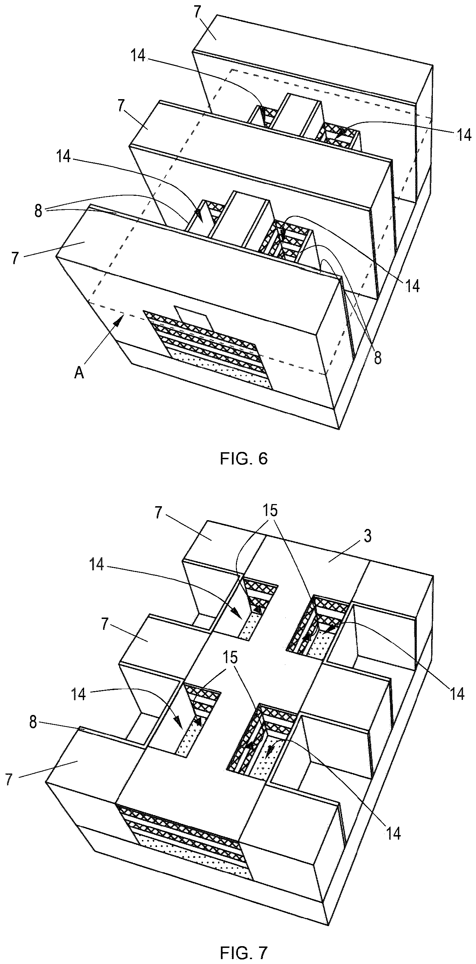

The next step is illustrated in Figures 6 and 7. The material of the SiGe layers 3 and the Si layer 4 is removed anisotropically relative to the dummy gate structures 7, the mask 6 and the dielectric spacers 8. The SiO₂ layer 2 may act as an etch stop layer or the etch process may be timed in order to stop without substantially removing the material of the SiO₂ layer 2. Etch recipes with the appropriate etch selectivity for removing SiGe and Si relative to the various materials of the dummy gates 7, the mask 6 and the spacers 8 are known in the art. This step creates lateral recesses 14 in the SiGe/Si stack 3,4, better visualized in Figure 7, which shows a section by a plane A parallel to the base substrate 1 and intersecting one of the SiGe layers 3. The U-shaped sidewalls 15 of the lateral recesses 14 are formed of U-shaped exposed portions of the SiGe and Si layers 3,4. In the image shown, the spacers 8 on the sides of the removed portions remain, forming a closure on the open end of the recesses 14. As stated above, it is possible that no spacers or only partially formed spacers are obtained at this location during the spacer formation process. In that case, the recesses 14 may be fully or partially open-ended.

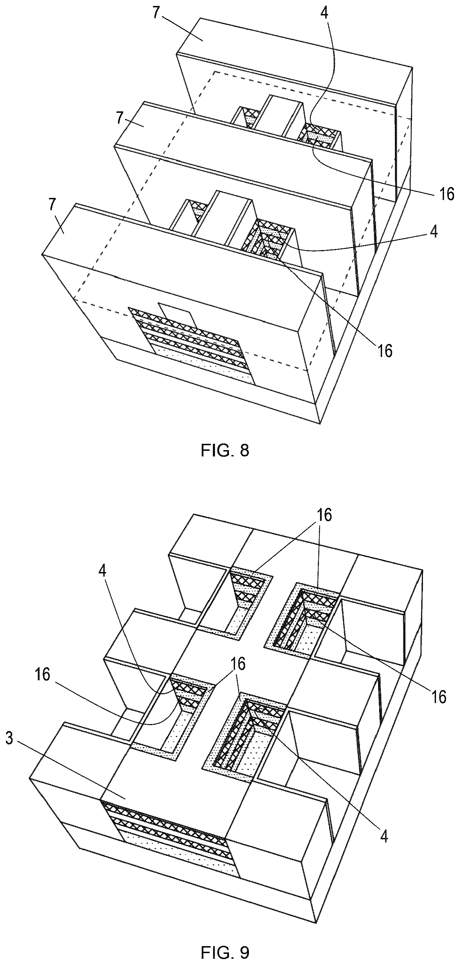

This is then followed by the creation of inner spacers 16, with reference to Figures 8 and 9. Inner spacers are formed by etching back the SiGe layers 3 laterally in the exposed U-shaped portions thereof to a depth of about 2-5 nm relative to the Si-layers 4 and replacing the removed SiGe by dielectric spacer material which may be the same as the material of the gate spacers 8. The formation of the inner spacers 16 is known as such and may be performed according to known techniques. The section view in Figure 9 visualizes the inner spacers 16 in terms of the depth to which they extend between the Si layers 4. Inner spacers are included in order to reduce the parasitic capacitance between the gate and the source or drain of the eventual transistor.

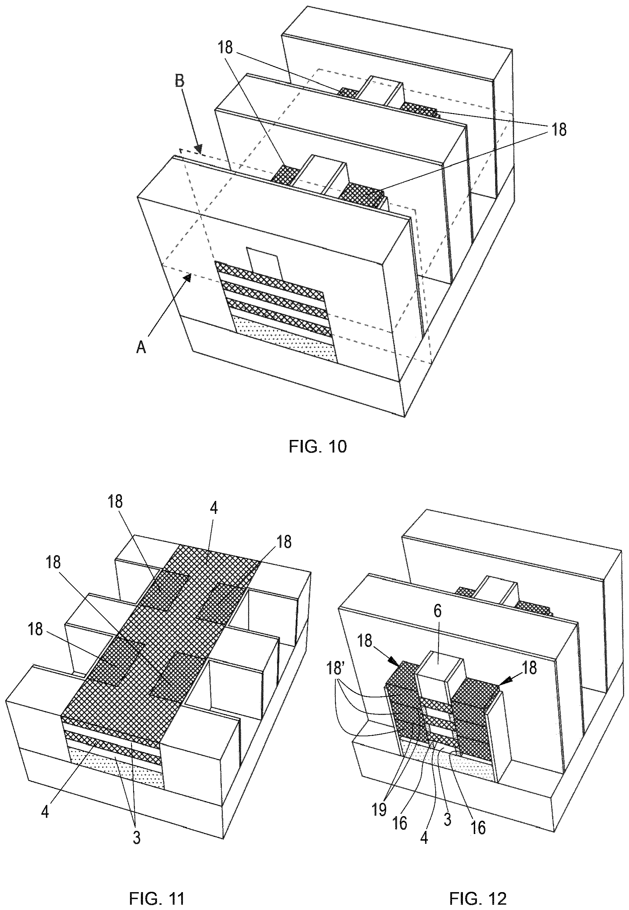

The next step is illustrated in Figures 10-12. Source and drain areas of eventual transistors are formed between the dummy gate structures 7, by epitaxial growth of semiconductor material starting from the 3 Si-surfaces of each of the exposed U-shaped sidewalls 15 of the lateral recesses 14. The semiconductor material is lattice-mismatched relative to Si. For example for the production of pMOS nanosheet transistors, compressive stress is required to optimize the carrier mobility in the channel. In this case, the source and drain areas may be formed of SiGe which has the appropriate lattice mismatch relative to Si to create said compressive stress. The use of SiGe for this purpose is known as such, but as explained in the introduction, with the traditional approach for growing SiGe between adjacent dummy gates, a dislocation plane appears which is likely to neutralize the strain within the SiGe, thereby making it impossible to create the desired compressive channel stress.

As visualized in the section in Figure 11 by plane A parallel to the base substrate 1, each of the U-shaped Si surfaces is part of a continuous crystalline structure 4. The material grown from said U-shaped Si surfaces is also crystalline and fully strained because of the lattice mismatch and because the growth fronts advancing from the U-shaped Si sidewall portions do not interact with any opposite growth fronts, and are therefore dislocation-free. As best visible in the section by plane B perpendicular to the base substrate 1 in Figure 12, an epitaxially grown volume 18 is obtained in the recesses 14. In Figure 12, it is seen that each volume 18 is an agglomerate of subvolumes 18' growing outward from the three U-shaped Si surfaces on the sidewall of a recess 14, said subvolumes 18' merging along horizontal interfaces 19, while the lower subvolume is spaced apart slightly from the SiO₂ layer 2. The volumes 18 may also fill the recesses 14 down to the bottom thereof.

Each Si layer 4 together with the volumes 18' grown on the side surfaces thereof are uniformly crystalline, i.e. they form a uniformly crystalline structure that is strained because of the lattice mismatch between the Si layers 4 and the grown material 18'. The epitaxially grown volumes 18 obtained in this way are thereby able to induce stress in the Si channels of the eventual transistors, wherein the volumes 18 will play the part of source or drain areas. As known in the art, appropriate doping elements (e.g. p dopants in the case of a pMOS) may be added to the volumes 18' during the epitaxial growth process, in view of said intended source/drain functionality.

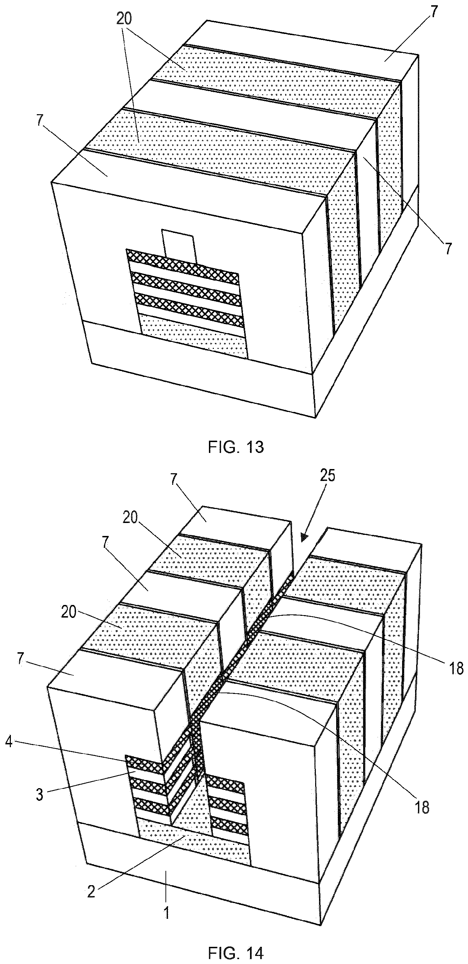

Reference is then made to Figure 13. Dielectric material 20 is deposited, completely filling the spaces between the dummy gates 7, and covering the structures between said dummy gates. The dielectric 20 is then planarized to a common level with the dummy gates 7. The dielectric used may be any dielectric suitable as a so-called interlayer dielectric (ILD) used for isolating the connections to gate, source and drain areas of nano-sheet transistors. It may be for example a low-k dielectric. In the embodiment shown, the ILD material 20 must be different from and selectively removable with respect to the material of the spacers 8, given that this material will again be removed relative to the spacers at a later stage of the process (see further).

An additional patterning step is then performed, with reference to Figure 14. By lithography and anisotropic etching, a trench 25 is formed through the dummy gates 7 and the SiGe/Si stack 3,4 of the original fin-shaped structure 5. The trench 25 extends in the longitudinal direction of said fin-shaped structure 5. The trench 25 is wider than the mask 6 but narrower than the SiGe/Si stack 3,4 so that the trench cuts said SiGe/Si stack in two preferably equal parts, by removing the mask 6 and (if present) the spacers 8 on the sides thereof. The anisotropic etch stops on the SiO₂ layer 2 by applying this layer as an etch stop layer or by a timed etch. On the sidewalls of the trench 25, portions of the original SiGe layers 3 and Si layers 4 are exposed, interspaced with the epitaxially grown volumes 18. Each of said volumes 18 is formed as an agglomerate of subvolumes 18' which form a uniformly crystalline structure with the Si layers 4 from which they are grown.

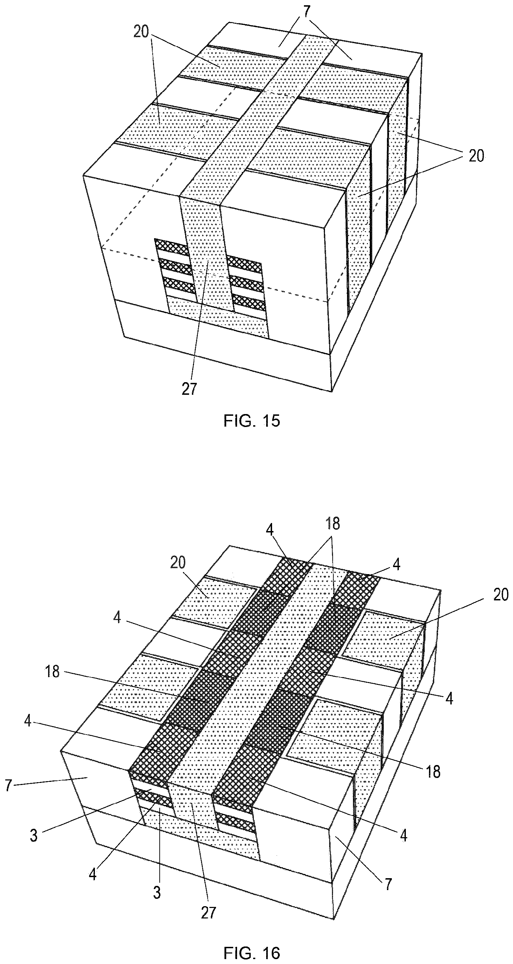

Then, as illustrated in Figure 15, a further layer of ILD material is deposited, which may be the same material as the material 20 deposited previously. The further ILD layer fills the trench 25 and is subsequently planarized to a common level with the dummy gates 7. The section view in Figure 16 illustrates that the obtained structure is suitable for producing a forksheet configuration of nanosheet transistors. The ILD-filled trench 25 forms a dielectric wall 27, with on either side thereof, a plurality of SiGe/Si stacks 3,4 interspaced by epitaxially grown volumes 18.

Therefore, from the process stage shown in Figures 15 and 16, process steps for producing fully operational nanosheet transistors may be performed according to known techniques. This includes removing the dummy gate structures 7 and thereafter removing the sacrificial SiGe layers 3 relative to the Si layers 4, so that the Si layers 4 are suspended as parallel sheets between two epitaxially grown volumes 18. With reference to Figures 17 and 18, dielectric layers 28 are then formed on the exposed surface of each of the Si-layers 4 and a metal gate 29 is formed around the dielectric layers 28. As seen in the section view in Figure 18, multiple pairs of two transistors can be obtained from this configuration, one on each side of the dielectric wall 27, each transistor comprising source or drain areas 18, a channel formed of three parallel Si-sheets 4, and a metal gate 29 separated from the channel by a gate dielectric 28. The gates 29 can be cut and connections to any number of source/drain areas 18 and gates 29 can be produced by known techniques and according to a given interconnection layout, thereby creating one or more operational transistors.

If not more than 3 dummy gates would be produced and only one fin-shaped structure 5, the method would lead to just two groups of a gate, source and drain on either side of the dielectric wall 27 and hence to potentially two transistors, which defines the minimal configuration obtainable by the method. Within the present context, a 'transistor' is only defined as such if the source, drain and gate are effectively contacted by electrical conductors coupled to a supply voltage or to another transistor or other device. So theoretically the method of the invention is capable of producing just one transistor in the above sense, if in the minimal configuration only one transistor is contacted. Therefore, the method is suitable for producing 'one or more transistors'. Of course, in most practical implementations the number of dummy gates and fin-shaped structures will be considerably higher, and the method enables the production of a large number of transistors, even though not all of the gate, source and drain areas may effectively be contacted.

In the embodiment described above, the transistors are formed on an isolation layer 2. This is the preferred case, because it ensures that the epitaxial growth for creating the source and drain areas 18 initiates only on the sidewalls of the recesses 14 and not on the bottom thereof, which would be the case if the transistors were built directly on a crystalline semiconductor wafer. When the growth also starts from the bottom of the recesses, this growth may interfere with the lateral growth fronts and thereby lead to dislocations. However, depending on the material of the base substrate 1 and the number of semiconductor nanosheets 4 in the initial stack, it may be possible that the bottom-up growth does not have a large impact on the lateral growth so that a major part of the source and drain areas are fully strained, and thereby able to create stress in one or more of the channel sheets. The production of transistors directly on a semiconductor substrate by the method of the invention is therefore not excluded from the invention scope.

In the embodiment shown in the drawings and described in detail hereabove, the hardmask 6 is formed on the fin-shaped structure 5 prior to the formation of the dummy gates 7. In an alternative embodiment, the dummy gates may be formed directly on the fin-shaped structure 5 and the mask 6 may be either a hardmask or a resist mask (i.e. a softmask) produced after the formation of the dummy gates. The function of the mask is however the same as described above, regardless of the mask type or the stage in the process at which it is produced : to cover a longitudinal portion of the fin-structure 5 in order to create the lateral cavities 14 as shown in Figures 6 and 7. Also, the mask, regardless of when and how it is produced, is removed when the longitudinal trench 25 is produced, as illustrated in Figure 14.

A nanosheet transistor produced by the method of the invention can be recognized by the fact that in any cross section parallel to the base substrate 1 and through at least one of the channel sheets 4, the source and drain areas 18 and the channel sheet 4 are uniformly crystalline, i.e. substantially no dislocations appear within the cross section. The 'at least one' is included to take into account embodiments of transistors processed directly on a semiconductor substrate, in which case a lower portion of the source and drain could include dislocations as explained in the previous paragraph. When the transistor is formed on a dielectric layer 2 however, the source and drain and the channel are uniformly crystalline in any cross section passing through any of the channel sheets 4. This is because said cross sections pass through a channel sheet 4 and through the volumes 18' grown directly on the side surfaces of the semiconductor layers 4 during the method of the invention, as described above.

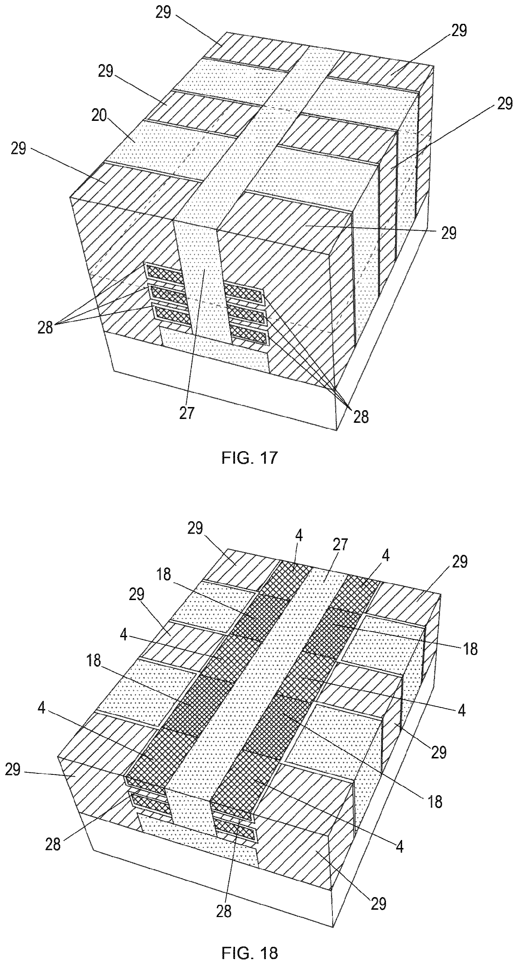

Nanosheet transistors produced according to the invention can be integrated in any known integration scheme, including schemes wherein complementary pMOS and nMOS transistors are built one on top of the other, also known as the CFET integration (complementary field effect transistors). The configuration illustrated in the drawings could for example be used to produce pMOS transistors on a bottom isolation layer 2 lying on a Si process wafer 1. Starting from the image shown in Figure 18, a layer of dielectric material may be produced on the planarized surface and nMOS transistors can then be produced on said dielectric layer, referred to as a the 'middle dielectric layer' of a CFET configuration, by the same method steps as described above, but using different materials given the fact that the stress requirements for an nMOS transistor are different from a pMOS transistor.

While the invention has been illustrated and described in detail in the drawings and foregoing description, such illustration and description are to be considered illustrative or exemplary and not restrictive. Other variations to the disclosed embodiments can be understood and effected by those skilled in the art in practicing the claimed invention, from a study of the drawings, the disclosure and the appended claims. In the claims, the word "comprising" does not exclude other elements or steps, and the indefinite article "a" or "an" does not exclude a plurality. The mere fact that certain measures are recited in mutually different dependent claims does not indicate that a combination of these measures cannot be used to advantage. Any reference signs in the claims should not be construed as limiting the scope.

## Claims

1. A method for producing one or more nano-sheet transistors, comprising the consecutively applied steps of :
- on a base substrate (1), producing at least one fin-shaped structure (5) extending in a longitudinal direction, the structure comprising a stack (3,4) of layers including one or more sacrificial layers (3) and one or more crystalline semiconductor layers (4) formed of a first semiconductor material, stacked in alternating order,
- producing at least three mutually parallel and spaced apart dummy gate structures (7) arranged transversely with respect to and fully overlapping the fin-shaped structure (5) and the mask (6),
- producing dielectric spacers (8) at least on the sidewalls of the dummy gate structures (7),
- patterning the stack (3,4) of sacrificial and semiconductor layers by removing the material of said layers relative to the dummy gate structures (7) and the spacers (8), and relative to a mask (6) formed prior to or after producing the dummy gate structures (7) and extending in the same longitudinal direction as the fin-shaped structure (5), so that two lateral recesses (14) having U-shaped sidewalls (15) are formed in said stack (3,4) on each side of at least one of the dummy gate structures (7) having adjacent dummy gates on either side, said sidewalls comprising exposed U-shaped portions of the sacrificial and semiconductor layers,
- on the U-shaped sidewalls (15), producing inner spacers (16) by etching back the exposed sacrificial material relative to the exposed semiconductor material, and replacing the thereby removed sacrificial material by a dielectric material,
- by epitaxial growth, growing a second semiconductor material in said lateral recesses (14), wherein :
∘ the second semiconductor material is lattice mismatched with respect to the first semiconductor material,
∘ the second semiconductor material grows outward starting from the exposed U-shaped portions of the layers (4) of the first semiconductor material,
∘ the growth continues until a volume (18) of the second semiconductor material is obtained in each of said lateral recesses,
- producing a dielectric layer (20) that fills the spaces between every pair of adjacent dummy gate structures (7) and planarizing said dielectric layer to a common level with the dummy gate structures (7),
- by lithography and etching, producing a trench (25) along the longitudinal direction of the fin-shaped structure (5), said trench cutting through the dummy gate structures (7) and the spacers (8), said trench being wider than the mask (6) but narrower than the fin-shaped structure (5), so that the mask (6) is removed while leaving portions of the stack (3,4) of alternating sacrificial and first semiconductor layers on either side of the trench,
- filling the trench (25) with a dielectric material, thereby forming a dielectric wall (27),
- removing the dummy gate structures (7) and the remaining parts of the sacrificial layers (3), producing gate dielectric layers (28) on the remaining parts of the first semiconductor layers (4) and producing metal gates (29) in direct contact with said gate dielectric layers (28) on both sides of the dielectric wall (27),
- producing electrical connections to at least one metal gate (29) and two epitaxially grown volumes (18) directly adjacent and on either side of said gate, thereby obtaining at least one nano-sheet transistor comprising a channel, a source area and a drain area.

2. The method according to claim 1, wherein the fin-shaped structure (5) comprises a dielectric layer (2) directly on the base substrate (1) and wherein said stack of alternating sacrificial and semiconductor layers (3,4) is formed directly on said dielectric layer (2).

3. The method according to claim 1 or 2, wherein spacers (8) are also formed on the sidewalls of the mask (6) and on the sidewalls of the fin-shaped structure (5).

4. The method according to any one of the preceding claims, wherein the stack of alternating sacrificial and semiconductor layers (3,4) comprises at least two semiconductor layers (4) and wherein one epitaxially grown volume (18) is formed in each of the recesses (14), said volume being obtained by merged subvolumes (18') growing outward from respective exposed U-shaped portions of the semiconductor layers (4).

5. The method according to any one of the preceding claims, wherein said dielectric layer (20) that fills the spaces between every pair of adjacent dummy gate structures (7) is removed after the step of producing the trench (25), and wherein a continuous layer (26) of dielectric material is thereafter produced, said continuous layer filling the trench (25) and the spaces between every pair of adjacent dummy gate structures (7).

6. The method according to any one of the preceding claims, wherein said mask is a hardmask (6) formed on the fin-shaped structure (5) and covering a central elongate portion of said structure, and wherein said hardmask is formed prior to the formation of the dummy gate structures (7).

7. The method according to any one of claims 1 to 5, wherein said mask is a hardmask or a resist mask formed after the formation of the dummy gates (7) and covering a central elongate portion of the fin-shaped structure (5).

8. A forksheet configuration comprising a base substrate (1), a dielectric wall (27) and two nanosheet transistors on opposite sides of said dielectric wall, each of the transistors comprising one or more channel sheets (4), a metal gate (29), a gate dielectric (28) between the channel sheets and the metal gate, a source and a drain area (18), **characterized in that** in any cross section parallel to the base substrate (1) and through at least one of the channel sheets (4), the source and drain areas (18) and the channel sheet (4) through which the cross section is taken are uniformly crystalline.

9. The configuration according to claim 8, wherein a dielectric layer (2) lies directly on the base substrate and wherein the dielectric wall (27) and the transistors are placed on the dielectric layer (2).

10. A semiconductor component comprising one or more transistors produced according to the method of any one of claims 1 to 7.

11. A semiconductor component comprising one or more forksheet configurations according to claim 8 or 9.
